# EUROPEAN PATENT SPECIFICATION

(11) **EP 0 676 806 B1**
(45) Date of publication and mention of the grant of the patent: **18.08.2004**
(21) Application number: 94309423.5
(22) Date of filing: 16.12.1994
(51) Int. Cl.: H01L 23/492, H01L 23/50, H01L 23/367, H05K 1/18

(54) **Ball grid array intergrated circuit package with high thermal conductivity**
Verpackung eines BGA-integrierten Schaltkreises mit hoher thermischer Leitfähigkeit
Emballage BGA pour circuit intégré avec conductibilité hautement thermique

(30) Priority: 08.04.1994 US 225138
(43) Date of publication of application: 11.10.1995
(73) Proprietor: STMicroelectronics, Inc., Carrollton, TX 75006-5039 (US)
(72) Inventor: Bond, Robert H., Plano, Texas 75023 (US); Hundt, Michael J., Double Oak, Texas 75067 (US)
(74) Representative: Palmer, Roger

(56) References cited:
- FR-A- 2 609 841
- US-A- 5 157 480
- US-A- 5 285 352

## Description

The present invention relates generally to semiconductor integrated circuit device packages, and is more particularly directed to thermal conduction techniques.

This application is related to European Patent Application No 94308577.9, the contents of which are incorporated herein by this cross reference.

Advances continue to be made in the manufacture of solid-state electronic devices, resulting in increasing functionality, density and performance of the integrated circuits. The amount of heat generated, and accordingly the amount of power needed to be dissipated, by modern integrated circuits generally increases with increases in the density and speed of the circuits. Removal of heat produced by the integrated circuits therefore continues to be of significant concern of modern integrated circuit package and system designers, considering the loss of performance and the degradation in reliability of integrated circuits when operated at elevated temperatures.

In addition, the trend toward more compact electronic systems is also continuing, exacerbating the thermal problem produced by the high-complexity and high-performance integrated circuits. For example, laptop or notebook sized computers have recently become quite popular, with continuing market pressure toward even smallercomputer systems such as personal digital assistants (PDA). However, these small systems eliminate many of the traditional techniques for heat removal available for large-scale computer systems, such as the use of fans for convection cooling of the integrated circuits. As such, many modern systems utilize thermal conduction as the primary mode of heat removal from the integrated circuits in the system.

Integrated circuit packages of the ball-grid-array (BGA) type have recently become popular in the field. Conventional BGA packages are similar in layout and arrangement to the pin-grid-array (PGA) packages, in providing a rectangular or square array of connections on the underside of the integrated circuit package. Instead of the pin connectors used in PGA packages, however, BGA packages utilize a solder ball located at each connector location. As is known in the art, the BGA package is attached to a printed circuit board by reflowing the solder balls to make connection to conductors at the surface of the printed circuit board. The BGA package provides the important advantage of being self-aligning, as the surface tension of the solder will tend to pull the BGA package into proper alignment with the corresponding conductors on the printed circuit board.

By way of further background, BGA integrated circuit packages of various types are known, including those of both the "cavity-up" and the "cavity-down" type. Conventional cavity-up BGA packages mount the integrated circuit chip with the circuitry facing up into a cavity (or onto the surface) of the package substrate, attach wire bonds between the package and the chip on its top side, and then either transfer mold or otherwise dispense a plastic over the chip and bond wires to provide environmental protection to the chip and wires. The solder balls are provided on the side of the substrate opposite the chip, and the packaged chip is then mounted to the system printed circuit board. It is known to use plated vias through the substrate at locations underlying the chip, but that are offset from conductors on the printed circuit board to which the packaged chip is mounted, to provide thermal conduction from the chip to its external environment.

Conventional cavity-down integrated circuit packages mount the integrated circuit chip into the cavity of, or onto the surface of, the package substrate, followed by attachment of bond wires thereto and molding or otherwise dispense a plastic around the chip. In this type of package, the solder balls are provided on the same side of the substrate as the chip, so that the chip is disposed up-side down or with the circuitry of the integrated circuit facing down after attachment of the packaged chip to the circuit board. It is known to mount the chip to a thermally conductive slug disposed within the substrate of a cavity-down package, with the slug exposed on its opposite side from the chip after mounting. A heat sink may be mounted to the exposed upper surface of the slug, so that the heat sink extends upwardly and facilitates convection cooling. This arrangement is not particularly well suited for modern small computing systems such as a laptop, notebook-sized, or hand-held computers, as these systems are not able to house a fan, and indeed are designed to have little or no flow of air within the housing ("zero-air-flow"), relying instead on conduction and natural convection heat transfer.

US-5157480 discloses a packaged semi-conductor device. The package includes an integrated circuit chip on a substrate which is encapsulated in a package body. Solder balls are attached to form the package semiconductor device. The package is mounted to a circuit board by forming an opening in the circuit board, extending a cold plate through the opening and securing. this in place. A reflow process may then be carried out which results in the package collapsing onto the top of the plate.

US-A-5285352 describes a package which includes a substrate having an opening filled with a thermal conductor and an integrated circuit chip mounted on the thermal conductor. This is encapsulated and solder balls are added to form a semiconductor device. The package is mounted to a circuit board by conducting a reflow process.

FR-A-2609841 describes a packaged integrated circuit device which includes a substrate having an opening with a unified ground electrode extending therethrough. An integrated chip is mounted in the package.

It is therefore an object of the present invention to provide an integrated circuit package having improved thermal conduction from the packaged chip to the system circuit board upon which it is mounted.

It is a further object of the present invention to provide an integrated circuit package having improved thermal conduction from the packaged chip to the system circuit board upon which it is mounted.

It is a further object of the present invention to provide such a package which is arranged in the cavity-up orientation.

It is a further objection of the present invention to provide such a package that is of the ball-grid-array (BGA) type.

It is a further object of the present invention to provide such a package that reduces the need for convection cooling.

Accordingly, the present invention provides a packaged integrated circuit mounted on an upper surface of a circuit board, said packaged integrated circuit comprising a substrate having an opening disposed therethrough and having a plurality of electrical conductors, a slug connected to the substrate and comprised of a thermally conductive material, an integrated circuit chip, mounted on an upper surface of the slug which is exposed in said opening in the substrate, and electrically connected to the conductors of the substrate and a plurality of solder balls, attached to a lower surface of the substrate in electrical connection with the conductors of the substrate and secured to the circuit board by a reflow procedure; characterised in that an undersurface of the slug contacts the upper surface of the circuit board, and a portion of the upper surface of the slug contacts the lower surface of the substrate, a portion of the slug between the substrate and the circuit board therein defining a stand-off distance between the upper surface of the circuit board and the lower surface of the substrate, which stand-off distance set by the slug determined a collapse distance for the solder balls during reflow, thereby providing effective thermal conduction through the slug between the chip and the circuit board.

The present invention also provides a method of mounting a packaged integrated circuit on an upper surface of a circuit board, comprising the steps of attaching a thermally conductive slug onto a substrate said substrate having an opening disposed therethrough and having a plurality of electrical conductors, mounting an integrated circuit chip on an upper surface of the slug which is exposed in said opening in the substrate and electrically connecting the integrated circuit chip to the plurality of electrical conductors, encapsulating the integrated circuit chip, attaching a plurality of solder balls to a lower surface of the substrate in electrical connection with the conductors of the substrate; whereby the packaged integrated circuit comprises the thermally conductive slug, the substrate, the integrated circuit chip and the solder balls, placing the packaged integrated circuit on an upper surface of the circuit board; and characterised in that said method further comprises the steps of attaching the conductive slug to the lower surface of the substrate wherein an undersurface of the slug lies below the plane of the lower surface of the substrate and conducting a reflow procedure such that the undersurface of the thermally conductive slug contacts the upper surface of the circuit board and a portion of the upper surface of the slug contacts the lower surface of the substrate, a portion of the slug between the substrate and the circuit board thereby defining a stand-off distance between the upper surface of the circuit board and the lower surface of the substrate, which stand-off distance set by the slug determines a collapse distance for the solder balls during reflow, thereby providing effective thermal conduction through the slug between the chip and the circuit board.

Other objects and advantages of the present invention will be apparent to those of ordinary skill in the art having reference to the following specification together with its drawings.

The invention may be implemented in a ball-grid-array (BGA) package of the cavity-up orientation. A thermally conductive slug, for example, made of copper, is attached to a package substrate having an opening therethrough; the substrate itself may be formed of a printed circuit board or ceramic substrate. A first surface of the slug lies below the plane of a first or underside surface of the substrate. A portion of a second surface of the slug is attached to the underside of the substrate. The integrated circuit chip is attached to the slug in the opening, and bonds are made between the bond pads of the chip and the package conductors, followed by encapsulation of the chip by molding or dispensing of a plastic. Solder balls are attached to the underside of the substrate package around the slug at locations corresponding to the terminals of the package. Upon attachment to the system circuit board, thermal and electrical connection is made between the slug and the system circuit board, along with electrical connection of the solder ball connectors to their respective system circuit board terminals. The slug thus provides direct thermal conduction between the chip and the system circuit board, to take advantage of the thermal conductivity of the system circuit board in conducting heat away from the chip.

The novel features believed characteristic of the invention are set forth in the appended claims. The invention itself, however, as well as a preferred mode of use, and further objects and advantages thereof, will best be understood by reference to the following detailed description of illustrative embodiments when read in conjunction with the accompanying drawings, wherein:
Figures 1A, 2A and 2B are cross sectional illustrations of an integrated circuit package according to the preferred embodiment of the present invention.
Figure 1B is a plan view of the integrated circuit package according to Figure 1A, including a cutaway portion.
Figures 3-4 are cross-sectional illustrations of an integrated circuit package according to an alternative preferred embodiment of the present invention.

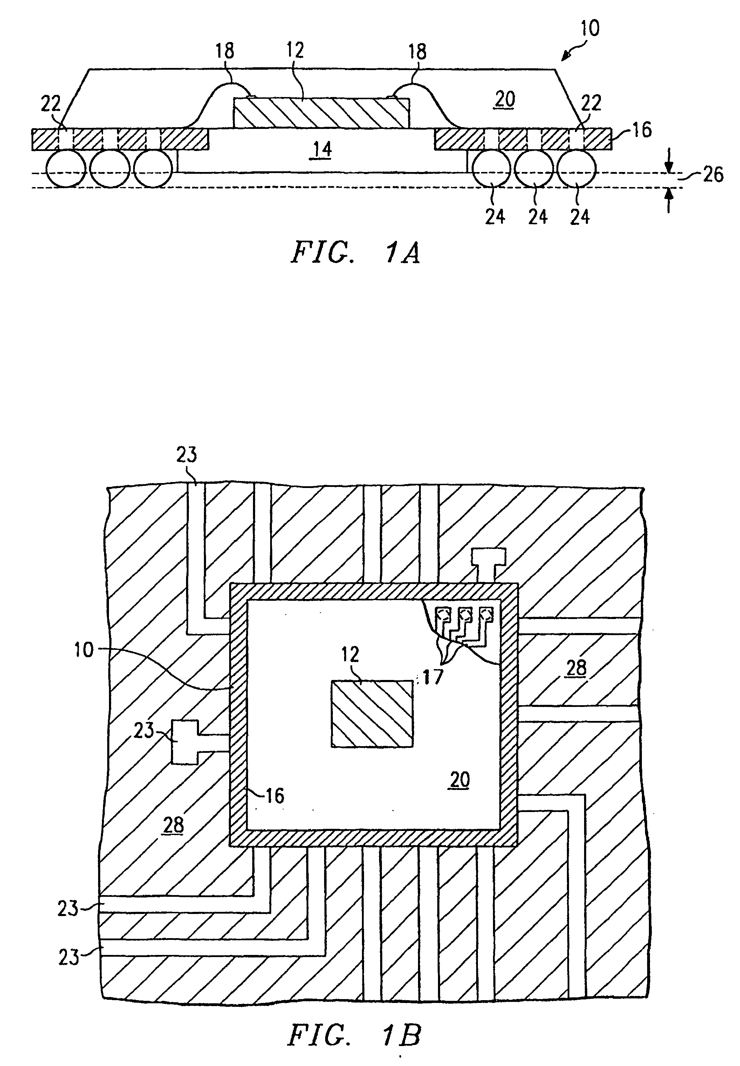

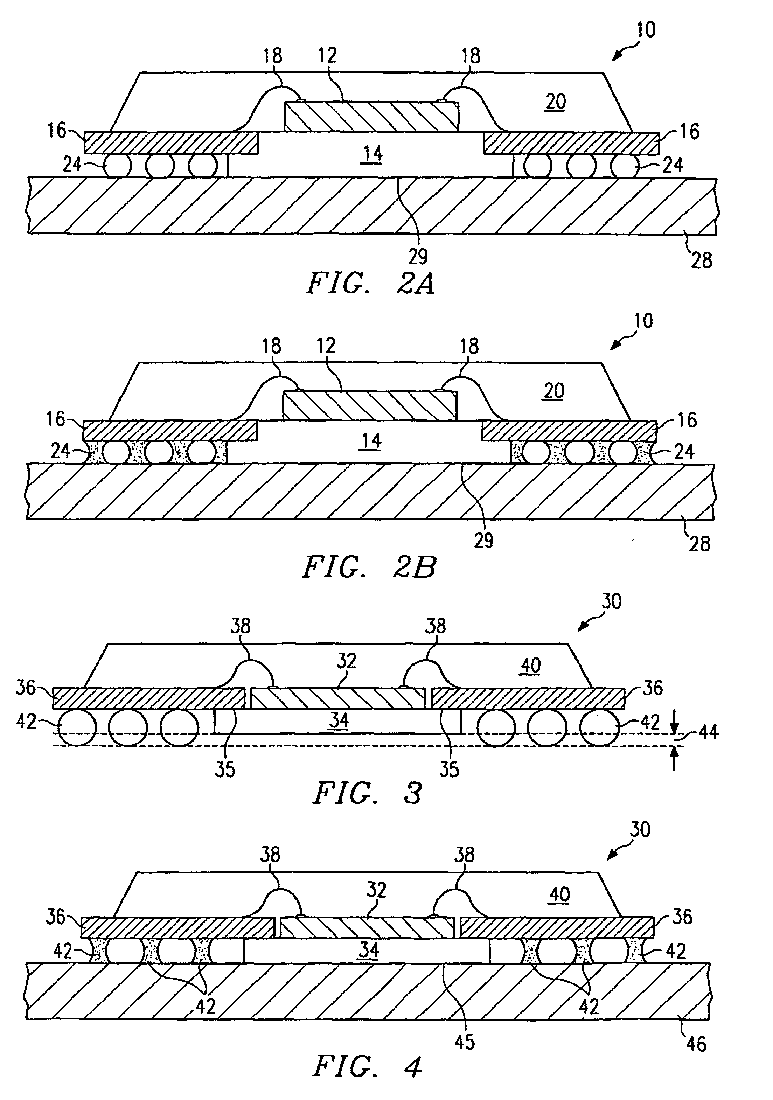

Referring now to Figures 1A-1B and 2A-2B, packaged integrated circuit 10 according to a first preferred embodiment of the invention will now be described in detail. While the following description is provided using the example of a package containing a single integrated circuit chip, it is of course to be understood that the present invention is also applicable to the packaging or mounting of multiple integrated circuit chips to a board, for example in a hybrid integrated circuit or multichip module.

The active element of packaged integrated circuit 10 is semiconductor chip 12, which is a solid-state integrated circuit device such as a microprocessor, memory, logic device, analog device or other electronic function implemented in a single-chip integrated circuit, as known in the art. According to this embodiment of the invention, chip 12 is attached on its bottom (inactive) surface to conductive slug 14, mounted within and below the plane of substrate 16.

Substrate 16 may be a ceramic substrate, printed circuit board, or other similar substrate having conductors 17 upon or within the substrate (see Figure 1B) for carrying electrical signals to and from chip 12, and having an opening or receptacle therein within which the conductive slug 14 is mounted. Bond wires 18 connect conductors 17 to bond pads on chip 12 in the conventional manner. Plated-through vias 22 make connection between conductors 17 on the top surface of substrate 16 and solder balls 24 on the lower surface of substrate 16. According to this embodiment of the invention, solder balls 24 are arranged in the conventional ball-grid-array manner around conductive slug 14, and correspond to lands or other surface conductors 23 (see Figure 1B) on the top surface of system circuit board 28 (see Figure 2A) to which packaged integrated circuit 10 is to be mounted. Encapsulant 20, formed of a plastic mold compound, an epoxy, a potting compound, or other conventional integrated circuit encapsulant, covers chip 12 and wires 18 to provide environmental and mechanical protection.

Conductive slug 14 is preferably formed of a material with high thermal conductivity, so that heat from chip 12 may be readily conducted therethrough. In addition, if electrical connection is to be made to chip 12, conductive slug 14 is also preferably electrically conductive. The preferred material for conductive slug 14 is believed to be copper, but other materials known in the art to be thermally conductive and, if desired, electrically conductive, may alternatively be used for slug 14.

Solder balls 24 are also disposed in an array manner beneath and in contact with substrate 16. Slug 14 and solder balls 24 are capable of conducting heat away from chip 12. Slug 14 may be connected to a ground plane within system circuit board 28 (see Figure 2A). The ground plane may be biased to ground or another substrate bias voltage, in which case slug 14 will also provide proper grounding for chip 12. While packaged integrated circuit 10, according to this embodiment of the invention, is shown in Figure 2A as attached to system circuit board 28, it is to be understood by those of ordinary skill in the art that packaged integrated circuit 10 will often be individually manufactured and sold, with the purchaser performing the installation of packaged integrated circuit 10 to system circuit board 28 in a computer or other end equipment.

The fabrication of packaged integrated circuit 10 begins with the insertion of slug 14 into the corresponding cavity of substrate 16; slug 14 is preferably epoxied into this cavity for mechanical integrity. Chip 12 is then mounted to the top surface of slug 14 by conventional die attach techniques, such as a conductive epoxy or eutectic mount. Bond wires 18 are then attached between substrate 16 and chip 12 by conventional techniques, such as thermocompression or ultrasonic bonding. Upon completion of the wire bond process, encapsulant 20 is formed over chip 12 and wires 18 in the conventional manner. In the example of Figure 1A, encapsulate 20 is formed by conventional transfer molding; alternatively, encapsulant 20 may be "globbed" over chip 12 and substrate 16 by dispensation and curing, in the conventional manner. Solder balls 24 are formed on the underside of substrate 24, in the conventional manner, for example, by way of a solder mask (not shown) on the underside of substrate 16.

Upon completion of the construction of packaged integrated circuit 10, and any desired electrical testing in packaged form, packaged integrated circuit 10 is ready for mounting to system circuit board 28 (see Figure 2A). Mounting of packaged integrated circuit 10 is preferably done by way of IR reflow or other conventional technique for the surface mounting of BGA packages to circuit boards. In addition, conductive slug 14 may be plated on the underside region at interface 29 between the slug 14 and system circuit board 28. Plating slug 14 will create a wettable surface during reflow which will bond to system circuit board 28 maximizing the area of thermal conduction from chip 12 to system circuit board 28. This thermal conduction path will enable system circuit board 28 to behave as a heat sink. Conductive slug 14 may be plated with conventional materials such as tin or nickel or other appropriate plating material. Alternatively, due to process variations, during reflow a small air gap or void may remain between slug 14 and system circuit board 28 without substantially impairing the ability of slug 14 to provide a thermal conduction path from chip 12 to system circuit board 28.

Conductive slug 14 will serve as a stand-off during solder reflow of solder bumps 24. As shown in Figure 1A, the specific collapse distance 26 of the solder bumps is determined by the height of conductive slug 14 below the plane of substrate 16. The shape of the solder bumps 24 after reflow will be determined by the starting volume of solder and the collapse distance 26. The shape of solder bumps 24 after reflow, by way of example, may remain substantially circular (see Figure 2A) or may result in an hour-glass shape (see Figure 2B). The hour-glass shape may be more desirable and may be optimized according to the specific collapse distance 26 and starting volume of solder.

Figures 3 and 4 illustrate, in cross-section, packaged integrated circuit 30 according to a second embodiment of the invention. According to this embodiment of the invention, packaged integrated circuit 30 includes chip 32 mounted upon thermally conductive slug 34. Slug 34 lies below the plane of substrate 36 and is attached to the underside of substrate 36 at locations 35 providing a lateral surface of substrate 36 to which slug 34 may be epoxied or otherwise securely fastened. In this arrangement, an opening is provide through substrate 36, to which chip 32 is mounted. This construction allows for a reduced height of the overall package and provides for the maximum area for the arrangement of bond wire lands on substrate 36 with minimum wire length, while maximizing the surface area of thermal conduction on the underside.

Bond wires 38 electrically connect conductors (not shown) in substrate 36 to pads on the surface of chip 32. In this embodiment of the invention, encapsulant 40 is disposed over the cavity of substrate 36, and thus over chip 32 and wires 38. Encapsulant 40, according to this embodiment of the invention, is dispensed by way of a syringe or other liquid dispenser, and is then cured in a conventional manner for so-called "chip-on-board" construction.

Solder balls 42 are attached to lands on the bottom of substrate 36 around thermally conductive slug 34. Vias (not shown) are provided within substrate 36 to provide electrical connection to the conductors in the substrate. A solder mask (not shown) may be provided on the underside of substrate 36 to aid in defining the location of solder balls 42, during the attachment in the conventional manner.

As in the first embodiment discussed hereinabove, packaged integrated circuit 30 is attached to system circuit board 46 (see figure 4) by way of infrared (IR) solder reflow or other conventional surface mount technique. Solder balls 42 and slug 34 may connect to a thermal conductor within system circuit board 46, thus providing a path of relatively low thermal resistance between chip 32 and system circuit board 46.

As described above with reference to the preferred embodiment, conductive slug 34 will serve as a stand-off during the solder reflow of solder bumps 42. The shape of the solder bumps after reflow will be determined by the volume of solder before reflow and the specific collapse distance 44 (see Figure 3). In addition, the underside of slug 34 may be plated to create a wettable surface during reflow at the interface 45 between slug 34 and system circuit board 46 to form a strong bond and enhance the thermal conduction from chip 32 to system circuit board 46.

While the invention has been described herein relative to its preferred embodiments, it is of course contemplated that modifications of, and alternatives to, these embodiments, such modifications and alternatives obtaining the advantages and benefits of this invention, will be apparent to those of ordinary skill in the art having reference to this specification and its drawings. It is contemplated that such modifications and alternatives are within the scope of this invention as subsequently claimed herein.

## Claims

1. A packaged integrated circuit (10, 30) mounted on an upper surface of a circuit board (28, 46), said packaged integrated circuit comprising:
a substrate (16, 36) having an opening disposed therethrough, and having a plurality of electrical conductors;
a slug (14, 34) connected to the substrate and comprised of a thermally conductive material;
an integrated circuit chip (12, 32), mounted on an upper surface of the slug which is exposed in said opening in the substrate, and electrically connected to the conductors of the substrate; and
a plurality of solder balls (24, 42), attached to a lower surface of the substrate in electrical connection with the conductors of the substrate and secured to the circuit board by a reflow procedure; **characterised in that**
an undersurface of the slug contacts the upper surface of the circuit board, and a portion of the upper surface of the slug contacts the lower surface of the substrate, a portion of the slug between the substrate and the circuit board thereby defining a stand-off distance between the upper surface of the circuit board and the lower surface of the substrate, which stand-off distance set by the slug determined a collapse distance for the solder balls during reflow, thereby providing effective thermal conduction through the slug between the chip and the circuit board.

2. The packaged integrated circuit of claim 1, wherein the upper surface of the slug (14,34) has first and second levels; wherein a portion of the slug extends through the opening whereby the second level of the upper surface is substantially planar with the second surface of the substrate (16, 36).

3. The packaged integrated circuit of claim 1, further comprising:
an encapsulant (20,40), disposed over the integrated circuit chip (12, 32), a portion of the second surface of the substrate, and a portion of the upper surface of the slug.

4. The packaged integrated circuit of claim 3, wherein the encapsulant comprises molded plastic.

5. The packaged integrated circuit of claim 1, wherein the substrate comprises either a printed circuit board or a ceramic substrate.

6. The packaged integrated circuit of claim 1, wherein the slug comprises copper.

7. The packaged integrated circuit of claim 1, wherein. the reformed shape for each of the plurality of solder balls after reflow, is either substantially round or is substantially hourglass.

8. The packaged integrated circuit of claim 1, further comprising:
a plated region of the first surface of the conductive slug.

9. A method of mounting a packaged integrated circuit (10, 30) on an upper surface of a circuit board (28,46), comprising the steps of:
attaching a thermally conductive slug(14, 34) onto a substrate (16, 36) said substrate havin gan opening disposed therethrough and having a plurality of electrical conductors;
mounting an integrated circuit chip (12,32) on an upper surface of the slug which is exposed in said opening in the substrate and electrically connecting the integrated circuit chip to the plurality of electrical conductors;
encapsulating the integrated circuit chip;
attaching a plurality of solder balls (24, 42) to a lower surface of the substrate in electrical connection with the conductors of the substrate;
whereby the packaged integrated circuit (10,30) comprises the thermally conductive slug, the substrate, the integrated circuit chip and the solder balls;
placing the packaged integrated circuit on an upper surface of the circuit board; and **characterised in that** said method further comprises the steps, of
attaching the conductive slug to the lower surface of the substrate wherein an undersurface of the slug lies below the plane of the lower surface of the substrate; and
conducting a reflow, procedure such that the undersurface of the thermally conductive slug (14, 34) contacts the upper surface of the circuit board and a portion of the upper. surface of the slug contacts the lower surface of the substrate, a portion of the slug between the substrate and the circuit board thereby defining a stand-off distance between the upper surface of the circuit board and the lower surface of the substrate, which stand-off distance set by the slug determines a collapse distance for the solder balls during reflow, thereby providing effective thermal conduction through the slug between the chip and the circuit board.

10. The method of claim 9, wherein the upper surface of the thermally conductive slug (14,34) has a first and second level, and wherein the step of attaching the thermally conductive slug to the upper surface of the substrate (16,36) further comprises the step of:
inserting the thermally conductive slug into the substrate wherein the first level of the upper surface is attached to the first surface of the substrate and the second level of the upper surface is substantially planar with the second surface of the substrate.

11. The method of claim 9, wherein the encapsulating step comprises:
transfer molding a plastic compound over the integrated circuit chip.

12. The method of claim 9, wherein the encapsulating step comprises the steps of:
dispensing a plastic over the integrated circuit chip; and
curing the dispensed plastic,

13. The method of claim 9, further comprising the step of: plating the under surface of the thermally conductive slug.

14. The method of claim 9, further comprising the step of: bonding a plurality of wire bonds (18, 38) to a top surface of the integrated circuit chip and the upper surface of the substrate.

15. The method of claim 14, wherein the step of bonding comprises either ultrasonic bonding or thermocompression.

## Patentansprüche

1. Eingehäuste integrierte Schaltung (10, 30), die auf einer Oberseite einer Leiterplatte (28, 46) befestigt ist, wobei die eingehäuste integrierte Schaltung umfasst:
ein Substrat (16, 36) mit einer durchgehenden Öffnung und mit mehreren elektrischen Leitern;
einen Block (14, 34), der mit dem Substrat verbunden ist und ein wärmeleitendes Material aufweist;
einen Chip mit einer integrierten Schaltung (12, 32), der auf einer Oberseite des Blocks, der in der Öffnung des Substrats freiliegt und elektrisch mit den Leitern des Substrats verbunden ist, befestigt ist; und
mehrere Lötperlen (24, 32), die mit einer Unterseite des Substrats in elektrischer Verbindung mit den Leitern des Substrats verbunden ist und mit der Leiterplatte durch ein Aufschmelzverfahren verbunden ist,
**dadurch gekennzeichnet,**
**dass** eine Unterseite des Blocks die Oberseite der Leiterplatte kontaktiert, und
**dass** ein Abschnitt der Oberseite des Blocks die Unterseite des Substrats kontaktiert, wobei dadurch ein Abschnitt des Blocks zwischen dem Substrat und der Leiterplatte einen Abstand zwischen der Oberseite der Leiterplatte und der Unterseite des Substrats definiert, wobei der Abstand, der durch den Block bestimmt ist, einen Kollapsabstand für die Lötperlen während des Aufschmelzens bestimmt, wodurch eine effektive Wärmeleitung durch den Block zwischen dem Chip und der Leiterplatte zur Verfügung gestellt wird.

2. Eingehäuste integrierte Schaltung nach Anspruch 1, wobei die Oberseite des Blocks (14, 32) eine erste und eine zweite Ebene aufweist, wobei ein Abschnitt des Blocks sich durch die Öffnung erstreckt, wobei die zweite Ebene der Oberseite des Blocks im Wesentlichen eben zu der zweiten Oberseite des Substrats (16, 36) ist.

3. Eingehäuste integrierte Schaltung nach Anspruch 1, die weiterhin umfasst:
ein Einkapselungsmittel (20, 40), das auf dem Chip mit der integrierten Schaltung (12, 32), auf einem Abschnitt der zweiten Oberfläche des Substrats und auf einem Abschnitt der Oberseite des Blocks aufgebracht ist.

4. Eingehäuste integrierte Schaltung nach Anspruch 3, wobei das Einkapselungsmittel einen spritzgußfähigen Kunststoff umfasst.

5. Eingehäuste integrierte Schaltung nach Anspruch 1, wobei das Substrat entweder eine Leiterplatte oder ein Keramiksubstrat umfasst.

6. Eingehäuste integrierte Schaltung nach Anspruch 1, wobei der Block Kupfer enthält.

7. Eingehäuste integrierte Schaltung nach Anspruch 1, wobei die veränderte Form jedes der mehreren Lötperlen nach dem Aufschmelzen entweder im Wesentlichen rund oder im wesentlichen sanduhrförmig ist.

8. Eingehäuste integrierte Schaltung nach Anspruch 1, die weiterhin umfasst:
einen metallisierten Bereich der ersten Oberfläche des leitenden Blockes.

9. Verfahren zum Befestigen einer eingehäusten integrierten Schaltung (10, 30) auf einer Oberseite einer Leiterplatte (28, 46), mit folgenden Schritten:
Anordnen eines wärmeleitenden Blockes (14, 34) auf einem Substrat (16, 36), wobei das Substrat eine durchgehende Öffnung und mehrere elektrische Leiter aufweist;
Befestigen eines Chips (12, 32) mit einer integrierten Schaltung auf einer Oberseite des Blocks, der in der Öffnung in dem Substrat freiliegt und elektrisch den Chip mit der integrierten Schaltung mit den mehreren elektrischen Leitern verbindet;
Einkapseln des Chips mit der integrierten Schaltung;
Anordnen von mehreren Lötperlen (24, 42) auf eine Unterseite des Substrats in elektrischer Verbindung mit den Leitern des Substrats;
wobei die eingehäuste integrierte Schaltung (10, 30), den wärmeleitenden Block, das Substrat, den Chip mit der integrierten Schaltung und die Lötperlen umfasst;
Anordnen der eingehäusten integrierten Schaltung auf einer Oberseite der Leiterplatte;
**dadurch gekennzeichnet,**
**dass** das Verfahren die weiteren Schritte umfasst:
Verbinden des leitenden Blockes mit der Unterseite des Substrats, wobei eine Unterseite des Blocks unter der Ebene der Unterseite des Substrats liegt; und
Durchführen eines Aufschmelzverfahrens, so dass die Unterseite des wärmeleitenden Blocks (14, 34) die Oberseite der Leiterplatte kontaktiert, und so dass ein Abschnitt der Oberseite des Blocks die Unterseite des Substrats kontaktiert, wodurch ein Abschnitt des Blocks zwischen dem Substrat und der Leiterplatte einen Abstand zwischen der Oberseite der Leiterplatte und der Unterseite des Substrats definiert, wobei der Abstand, der durch den Block bestimmt ist, einen Kollapsabstand für die Lötperlen während des Aufschmelzens bestimmt, wodurch eine effektive Wärmeleitung durch den Block zwischen dem Chip und der Leiterplatte zur Verfügung gestellt wird.

10. Verfahren nach Anspruch 9, wobei die Oberseite des wärmeleitenden Blocks (14, 34) eine erste und eine zweite Ebene umfasst, wobei der Schritt des Befestigen des wärmeleitenden Blockes an der Oberseite des Substrats (16, 36) weiterhin den Schritt umfasst:
Einfügen des wärmeleitenden Blockes in das Substrat, wobei die erste Ebene der Oberseite mit der ersten Oberfläche des Substrats verbunden ist und wobei die zweite Ebene der Oberseite im Wesentlichen eben zu der zweiten Oberfläche des Substrats ist.

11. Verfahren nach Anspruch 9, wobei der Schritt des Einkapselns weiterhin umfasst:
Spritzgießen einer Kunststoffverbindung über den Chip mit der integrierten Schaltung.

12. Verfahren nach Anspruch 9, wobei der Schritt des Einkapselns weiterhin die Schritte umfasst:
Aufbringen eines Kunststoffs auf den Chip mit der integrierten Schaltung; und
Ausheilen des aufgebrachten Kunststoffs.

13. Verfahren nach Anspruch 9, das weiterhin den Schritt umfasst:
Metallisieren der Unterseite des wärmeleitenden Blocks.

14. Verfahren nach Anspruch 9, das weiterhin den Schritt umfasst:
Verbinden von mehreren Drahtverbindungen (18, 38) mit einer Oberseite des Chips mit der integrierten Schaltung und der Oberseite des Substrats.

15. Verfahren nach Anspruch 14, wobei der Schritt des Verbindens entweder ein Ultraschallverbinden oder ein Thermokompressionsverbinden umfasst.

## Revendications

1. Circuit intégré emballé (10, 30) monté sur la face supérieure d'une carte de circuits (28, 46), lequel circuit intégré emballé comprend :
- un substrat (16, 36) traversé par une ouverture et possédant une pluralité de conducteurs électriques ;
- une plaquette (14, 34) connectée au substrat et composée d'un matériau conducteur thermique ;
- une puce de circuit intégré (12, 32) montée sur une face supérieure de la plaquette qui est exposée dans ladite ouverture du substrat, et connectée électriquement aux conducteurs du substrat ; et
- une pluralité de billes de soudure (24, 42) liées à une face inférieure du substrat en connexion électrique avec les conducteurs du substrat et fixées à la carte de circuits par un procédé de refusion ;
**caractérisé en ce qu'**une face inférieure de la plaquette vient en contact avec la face supérieure de la carte de circuits, et une partie de la face supérieure de la plaquette vient en contact avec la face intérieure du substrat, une partie de la plaquette située entre le substrat et la carte de circuits définissant ainsi une distance d'écartement entre la face supérieure de la carte de circuits et la face inférieure du substrat, laquelle distance d'écartement définie par la plaquette détermine une distance d'affaissement des billes de soudure pendant la refusion, ce qui établit une conduction thermique efficace à travers la plaquette entre la puce et la carte de circuits.

2. Circuit intégré emballé selon la revendication 1, **caractérisé en ce que** la face supérieure de la plaquette (14, 34) possède un premier niveau et un second niveau, une partie de la plaquette s'étendant à travers l'ouverture de telle sorte que le second niveau de la face supérieure se trouve sensiblement dans le même plan que la seconde face du substrat (16, 36).

3. Circuit intégré emballé selon la revendication 1, **caractérisé en ce qu'**il comprend en outre un enrobage (20, 40) disposé par-dessus la puce de circuit intégré (12, 32), une partie de la seconde face du substrat et une partie de la face supérieure de la plaquette.

4. Circuit intégré emballé selon la revendication 3, **caractérisé en ce que** l'enrobage se compose de plastique moulé.

5. Circuit intégré emballé selon la revendication 1, **caractérisé en ce que** le substrat se compose soit d'une carte de circuits imprimés, soit d'un substrat en céramique.

6. Circuit intégré emballé selon la revendication 1, **caractérisé en ce que** la plaquette est composée de cuivre.

7. Circuit intégré emballé selon la revendication 1, **caractérisé en ce que** la forme reconstituée de chacune des billes de soudure après la refusion est sensiblement circulaire ou en forme de sablier.

8. Circuit intégré emballé selon la revendication 1, **caractérisé en ce qu'**il comprend en outre une région plaquée dans la première face de la plaquette conductrice.

9. Procédé de montage d'un circuit intégré emballé (10, 30) sur une face supérieure d'une carte de circuits (28, 46), comprenant les étapes de :
- fixation d'une plaquette conductrice thermique (14, 34) sur un substrat (16, 36), lequel substrat est traversé par une ouverture et possède une pluralité de conducteurs électriques ;
- montage d'une puce de circuit intégré (12, 32) sur une face supérieure de la plaquette exposée dans ladite ouverture du substrat et connexion électrique de la puce de circuit intégré à la pluralité de conducteurs électriques ;
- enrobage de la puce de circuit intégré ;
- fixation d'une pluralité des billes de soudure (24, 42) à une face inférieure du substrat en connexion électrique avec les conducteurs du substrat ;
de sorte que le circuit intégré emballé (10, 30) comprend la plaquette thermiquement conductrice, le substrat, la puce de circuit intégré et les billes de soudure ;
- pose du circuit intégré emballé sur une face supérieure de la carte de circuits ;
et **caractérisé en ce qu'**il comprend en outre les étapes de :
- fixation de la plaquette conductrice sur la face inférieure du substrat, de sorte qu'une face inférieure de la plaquette se trouve en dessous du plan de la face inférieure du substrat ; et
- exécution d'une opération de refusion de telle sorte que la face inférieure de la plaquette conductrice thermique (14, 34) vienne en contact avec la face supérieure de la carte de circuits et une partie de la face supérieure de la plaquette vienne en contact avec la face inférieure du substrat, une partie de la plaquette située entre le substrat et la carte de circuits définissant ainsi une distance d'écartement entre la face supérieure de la carte de circuits et la face inférieure du substrat, laquelle distance d'écartement définie par la plaquette détermine une distance d'affaissement des billes de soudure pendant la refusion, créant ainsi une conduction thermique efficace à travers la plaquette entre la puce et la carte de circuits.

10. Procédé selon la revendication 9, **caractérisé en ce que** la face supérieure de la plaquette conductrice thermique (14, 34) possède un premier niveau et un second, et **en ce que** l'étape de fixation de la plaquette conductrice thermique sur la face supérieure du substrat comprend en outre l'étape d'insertion de la plaquette conductrice thermique dans le substrat de telle sorte que le premier niveau de la face supérieure soit fixé à la première face du substrat et le second niveau de la face supérieure se trouve sensiblement dans le même plan que la seconde face du substrat.

11. Procédé selon la revendication 9, **caractérisé en ce que** l'étape d'enrobage comprend le moulage par transfert d'un composé plastique sur la carte de circuits intégrés.

12. Procédé selon la revendication 9, **caractérisé en ce que** l'étape d'enrobage comprend les étapes de :
- dépose d'un plastique par-dessus la puce de circuit intégré ; et
- polymérisation du plastique déposé.

13. Procédé selon la revendication 9, **caractérisé en ce qu'**il comprend en outre l'étape de placage de la face inférieure de la plaquette conductrice thermique.

14. Procédé selon la revendication 9, **caractérisé en ce qu'**il comprend en outre l'étape de soudage d'une pluralité de soudures de fils (18, 38) sur une face supérieure de la puce de circuit intégré et la face supérieure du substrat.

15. Procédé selon la revendication 14, **caractérisé en ce que** l'étape de soudage est réalisée par soudage par ultrasons ou thermocompression.
